**Europäisches Patentamt**

**European Patent Office**

**Office européen des brevets**

(19)

(11) Veröffentlichungsnummer: **0 058 747**
A1

(12)

# EUROPÄISCHE PATENTANMELDUNG

(21) Anmeldenummer: **81107812.0**

(22) Anmeldetag: **01.10.81**

(51) Int. Cl.³: **H 03 C 3/09**

(30) Priorität: **19.02.81 DE 3106058**

(43) Veröffentlichungstag der Anmeldung: **01.09.82**
**Patentblatt 82/35**

(84) Benannte Vertragsstaaten: **AT DE FR GB NL**

(71) Anmelder: **ROBERT BOSCH GMBH, Postfach 50, D-7000 Stuttgart 1 (DE)**

(72) Erfinder: **Franke, Manfred, Stubenrauchstrasse 53, D-1000 Berlin 41 (DE)**
Erfinder: **Waizenegger, Dieter, Ing.-grad., Barsekowstrasse 27, D-1000 Berlin 41 (DE)**

(74) Vertreter: **Schmidt, Hans-Ekhardt, Robert Bosch GmbH Geschäftsbereich Elektronik Patent- und Lizenzabteilung Forckenbeckstrasse 9-13, D-1000 Berlin 33 (DE)**

(54) **Verfahren zur Frequenzaufbereitung für Funksende- und -empfangsgeräte.**

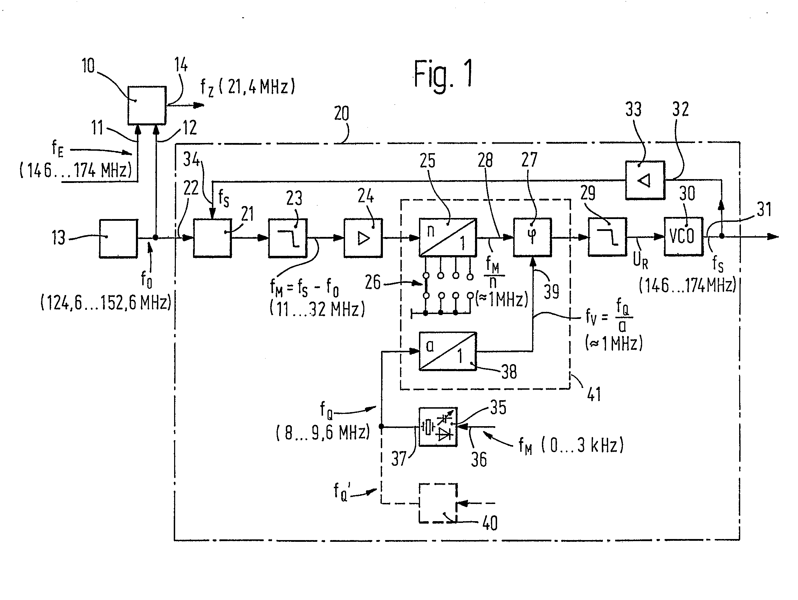

(57) Es wird ein Verfahren vorgeschlagen, das zur Frequenzaufbereitung für Funksende- und -empfangsgeräte dient und das ohne große Änderungen der frequenzbestimmenden Bauelemente die von der Empfangsfrequenz abgeleiteten Sendefrequenzen der Funkkanäle für das Wechselsprechen, Gegensprechen und das Ober- oder Unterband bereitstellt. Nach dem erfindungsgemäßen Verfahren wird zur Grobabstimmung der Sendefrequenz ($f_S$) eine Mischfrequenz ($f_M$) die aus der Frequenz des Empfangsoszillators (13) und der Frequenz eines spannungsgesteuerten Oszillators (30) eines PLL-Sendeoszillators (20) gebildet wird, in ganzzahligen Stufen geteilt. Eine Feinabstimmung erfolgt durch Ändern der von einem Quarzoszillator (25) abgeleiteten Vergleichsfrequenz ($f_V$) um einen im Verhältnis zu der Mischfrequenz kleinen Frequenzwert. Für die zu erzeugende Sendefrequenz gilt die Beziehung $f_S = f_E \pm n \cdot f_V$, wobei n das ganzzahlige Teilungsverhältnis ist (Fig. 1).

EP 0 058 747 A1

ACTORUM AG

4/81
EK/PLI Scht/Li
16.Februar 1981


ROBERT BOSCH GMBH, 7OOO Stuttgart 1


Verfahren zur Frequenzaufbereitung
für Funksende- und -empfangsgeräte

Stand der Technik

Die Erfindung geht aus von einem Verfahren zur Frequenzaufbereitung nach der Gattung des Hauptanspruchs.

Es sind Frequenzaufbereitungsschaltungen für Funksende- und -empfangsgeräte bekannt, bei denen eine erste Frequenz und eine zweite Frequenz addiert oder subtrahiert werden, um eine dritte Frequenz zu erhalten. Die erste Frequenz ist zum Beispiel die Frequenz eines Empfangsoszillators und die dritte Frequenz die Sendefrequenz des Funkgerätes. Je nach der gewählten Höhe der zweiten Frequenz ergibt sich dann ein bestimmter Frequenzabstand zwischen der Sendefrequenz und der Empfangsfrequenz, so daß Wechselsprech- oder Gegensprech-Funkkanäle entstehen. Die bekannte Art der Frequenzaufbereitung geht von einer speziellen Phase-locked-loop(PLL)-Schaltung aus, die als wesentliche Bestandteile eine Mischstufe, eine Phasenvergleichsstufe, einen Referenzoszillator, ein Tiefpaßfilter und einen spannungsgesteuerten Oszillator aufweist. Die dritte Frequenz wird mittels des spannungsgesteuerten Oszillators direkt und die zweite Frequenz durch einen vorzugsweise in der Frequenz modulierbaren quarzgesteuerten Oszillator erzeugt. Wird der Quarzoszillator dann mit einem niederfrequenten Signal, zum Beispiel einem Sprechsignal, moduliert, so ist auch die dritte Frequenz ent-

- 2 -

sprechend moduliert. Dazu muß das Tiefpaßfilter eine ausreichend hohe Grenzfrequenz von mindestens 10 kHz besitzen.

Derartige bekannte Frequenzaufbereitungsschaltungen arbeiten
zufriedenstellend. Es ergeben sich jedoch Nachteile, wenn bei
serienmäßig hergestellten Funksende- und -empfangsgeräten die
zweite Frequenz - im folgenden Mischfrequenz genannt - je nach
der geplanten Einsatzart (Wechselsprechen, Gegensprechen,
Frequenzen im Ober- oder Unterband) innerhalb einer verhältnismäßig großen Bandbreite von zum Beispiel 10 MHz umgeschaltet
werden muß. Dann ist nicht nur ein Auswechseln des Schwingquarzes des Quarzoszillators, sondern auch eine vollständige
Änderung aller frequenzbestimmenden Bauelemente dieses
Oszillators nötig.

Vorteile der Erfindung

Das erfindungsgemäße Verfahren zur Frequenzaufbereitung mit den
kennzeichnenden Merkmalen des Hauptanspruchs hat den Vorteil,
daß der Quarzoszillator trotz verhältnismäßig großer Frequenzänderungen der Mischfrequenz von zum Beispiel 11 bis 32 MHz
nur für einen verhältnismäßig kleinen Frequenzbereich von zum
Beispiel 8 bis 9 MHz ausgelegt zu sein braucht. Auf diese Weise
kommt man ohne eine Änderung der frequenzbestimmenden Bauelemente, mit Ausnahme des Schwingquarzes, aus.

Durch die in den Unteransprüchen aufgeführten Maßnahmen sind
vorteilhafte Weiterbildungen und Verbesserungen des im Hauptanspruch angegebenen Verfahrens möglich. Besonders vorteilhaft
ist es, wenn bei dem Verfahren dem Quarzoszillator ein
Frequenzteiler mit festem Teilungsverhältnis zugeordnet ist,
der die Frequenz des Quarzoszillators derart teilt, daß die
Vergleichsfrequenz in der Größenordnung der geteilten Mischfrequenz liegt. Auf diese Weise können für den Quarzoszillator
Schwingquarze Verwendung finden, die aufgrund ihrer Resonanzfrequenz verhältnismäßig leicht herzustellen sind.

Zeichnung

Ein Ausführungsbeispiel der Erfindung ist in der Zeichnung
anhand zweier Figuren dargestellt und in der nachfolgenden
Beschreibung näher erläutert. Die Zeichnung zeigt in

Fig. 1   ein vereinfachtes Blockschaltbild für die
         erfindungsgemäße Frequenzaufbereitung und

Fig. 2   ein ausführlicheres Schaltbild des erfindungsgemäßen PLL-Sendeoszillators.

Beschreibung der Erfindung

In Fig. 1 bezeichnet 10 eine Mischstufe für den Empfangsteil
eines Funksende- und -empfangsgerätes. An einem ersten Eingang 11 liegt die Empfangsfrequenz $f_E$ eines bestimmten
Empfangsfrequenzbereiches von zum Beispiel 146 bis 174 MHz
und an einem zweiten Eingang 12 eine Oszillatorfrequenz $f_O$
eines durchstimmbaren Empfangsoszillators 13. Der Empfangsoszillator ist außerdem mit einem Phase-locked-loop(PLL)-
Sendeoszillator 20 zum Erzeugen einer NF-modulierten Sendefrequenz $f_S$ verbunden; vgl. den in Fig. 1 durch strichpunktierte Linien umrahmten Schaltungsteil. Der PLL-Oszillator 20
umfaßt eine Reihenschaltung aus einer Mischstufe 21, deren
erster Eingang 22 mit dem Empfangsoszillator 13 verbunden
ist, einem ersten Tiefpaßfilter 23, einem Verstärker 24,
einem Frequenzteiler 25 mit durch einen Schalter 26 in
Stufen einstellbarem Teilungsverhältnis, einer Phasenvergleichsstufe 27, deren erster Eingang 28 mit dem Ausgang des
Frequenzteilers 25 verbunden ist, einem zweiten Tiefpaßfilter 29 und einem spannungsgesteuerten Oszillator 30,
dessen Ausgang 31 den Ausgang des PLL-Oszillators 20 bildet.
Von dem Ausgang 31 führt eine Leitung 32 über einen Verstärker 33 an einen zweiten Eingang 34 der Mischstufe 21. Ein modulierbarer Quarzoszillator 35 weist einen Modulationseingang 36 für die Niederfrequenz von zum Beispiel
0 bis 3 kHz und einen Ausgang 37 auf, an dem die modulierte
Quarzoszillatorfrequenz $f_Q$ von zum Beispiel 8 bis 9,6 MHz
zur Verfügung steht. Der Ausgang 37 des Quarzoszillators
ist über einen Frequenzteiler 38 mit festem Teilungsverhältnis mit einem zweiten Eingang 39 der Phasenvergleichsstufe 27 verbunden. An den Ausgang 37 kann sich ein weiterer
Quarzoszillator 40 anschließen, dessen Oszillatorfrequenz $f_Q'$
einen anderen Frequenzbereich als die Frequenz $f_Q$ umfaßt.

Mit 41 ist in Fig. 1 ein Schaltungsteil bezeichnet, der die
Frequenzteiler 25 und 38 sowie die Phasenvergleichsstufe 27
umfaßt. Dieser Schaltungsteil kann vorzugsweise in integrierter Schaltungstechnik ausgeführt sein. In die Schaltung
kann gegebenenfalls auch noch der aktive Teil des Quarzoszillators 35 einbezogen werden.

Das vorstehend beschriebene Blockschaltbild nach Fig. 1 hat
folgende Funktion.

Aus der Empfangsfrequenz $f_E$ des Empfangsteils des Funksende-
und -empfangsgerätes und der Oszillatorfrequenz $f_O$ des
Empfangsoszillators 13 bildet die Mischstufe 10 durch Mischung
eine Zwischenfrequenz $f_Z$ von zum Beispiel 21,4 MHz. Die
Zwischenfrequenz wird in dem Empfangsteil in der üblichen
Weise weiterverarbeitet.

Zu jeder Empfangsfrequenz, die mit dem Funksende- und
-empfangsgerät empfangen werden kann, gehört eine einen
bestimmten Frequenzabstand davon aufweisende Sendefrequenz $f_S$.
Die Größe des Frequenzabstandes hängt von der gewählten Übertragungsart ab (Wechselsprechen, Gegensprechen, Oberband,
Unterband) und muß daher einstellbar sein. Hierzu wird von
der Frequenzaddition Gebrauch gemacht, und zwar werden die

Sendefrequenz $f_S$ des zunächst auf einer mittleren Frequenz schwingenden spannungsgesteuerten Oszillators 30 und die Empfangsoszillatorfrequenz $f_O$ des Empfangsoszillators 13 in der Mischstufe 21 gemischt. Das erste Tiefpaßfilter 23 hat eine derart bemessene Grenzfrequenz, das nur die Differenzfrequenz $f_S - f_O$ als Mischfrequenz $f_M$ weitergeleitet wird.

Nach einer Verstärkung der Signalspannung in dem Verstärker 24 wird die Mischfrequenz durch eine mittels des binären Schalters 26 vorwählbare ganze Zahl n geteilt, so daß dem ersten Eingang 28 der Phasenvergleichsstufe 27 eine Frequenz $\frac{f_M}{n}$ zugeführt wird, die etwa der Vergleichsfrequenz $f_V$ entspricht. Die Vergleichsfrequenz $f_V$ entsteht durch Teilung der Frequenz $f_Q$ des Quarzoszillators 35 in einem festen Teilungsverhältnis 1 : a. Für die Sendefrequenz $f_S$ gilt allgemein $f_S = f_E \pm n \cdot f_V$, wobei n das ganzzahlige Teilungsverhältnis des Frequenzteilers 25 ist. Durch die Einstellung des Schalters 26 wird eine Grobabstimmung und durch die Wahl der Resonanzfrequenz des Schwingquarzes des Quarzoszillators 35 eine Feinabstimmung vorgenommen, ohne daß andere frequenzbestimmende Bauelemente des Quarzoszillators ausgewechselt werden müssen. Solange die Phasenvergleichsstufe 27 eine Phasendifferenz feststellt, liefert der Ausgang des zweiten Tiefpaßfilters 29 eine Regelspannung $U_R$, mit der der spannungsgesteuerte Oszillator 30 nachgeregelt wird. Die Nachregelung erfolgt solange, bis der PLL-Sendeoszillator eingerastet ist.

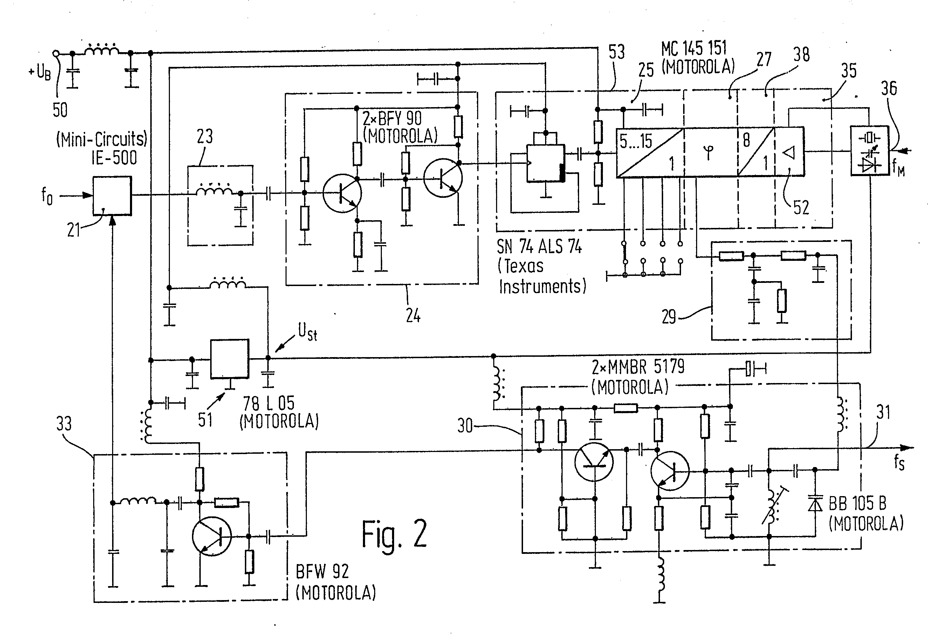

Die Fig. 2 zeigt ein ausführlicheres Schaltbild des PLL-Sendeoszillators 20 nach Fig. 1. In Fig. 2 sind für die einzelnen Stufen die gleichen Bezugszahlen wie in Fig. 1 verwendet. Die zu jeweils einer der Stufen gehörenden Bauelemente sind durch strichpunktierte Linien umrahmt.

In Fig. 2 sind außerdem noch die Mittel zur Stromversorgung gezeigt. Dazu gehört ein Anschluß 50, der mit dem positiven Pol einer Gleichspannungsquelle mit der Spannung $U_B$ verbunden ist. Von der Gleichspannung wird über eine Spannungsstabilisierungsschaltung 51 eine stabilisierte Gleichspannung $U_{st}$ abgeleitet, die zur Stromversorgung des Verstärkers 24 und des spannungsgesteuerten Oszillators 30 dient. Ein Teil des Frequenzteilers 25 sowie die Phasenvergleichsstufe 27, der Frequenzteiler 38 und der aktive Teil 52 des Quarzoszillators 35 sind zu einer integrierten Schaltung 53 zusammengefaßt.

4/81
EK/PLI Scht/Li
16.Februar 1981

ROBERT BOSCH GMBH, 7OOO Stuttgart 1

Ansprüche

1. Verfahren zur Frequenzaufbereitung für Funksende- und -empfangsgeräte mit einem Empfangsoszillator und einem Phase-locked-loop(PLL)-Sendeoszillator, der aus der Frequenz des Empfangsoszillators und der Frequenz eines spannungsgesteuerten Oszillators des PLL-Sendeoszillators eine Mischfrequenz bildet, die in Frequenz und Phase mit einer von einem Quarzoszillator gelieferten Vergleichsfrequenz verglichen wird, und der aus dem Vergleich ein Regelkriterium für den spannungsgesteuerten Oszillator liefert, dadurch gekennzeichnet, daß eine Grobabstimmung der Sendefrequenz ($f_S$) durch Teilung der Mischfrequenz ($f_M$) in ganzzahligen Stufen und eine Feinabstimmung durch Ändern der Vergleichsfrequenz ($f_V$) um einen im Verhältnis zu der Mischfrequenz kleinen Frequenzwert vorgenommen wird und daß für die Sendefrequenz die Beziehung $f_S = f_E \pm n \cdot f_V$ gilt, wobei n das ganzzahlige Teilungsverhältnis ist.

2. Vorrichtung zur Durchführung des Verfahrens nach Anspruch 1, gekennzeichnet durch einen Frequenzteiler (25) mit einstellbarem Teilungsverhältnis zum Teilen der Mischfrequenz ($f_M$) in ganzzahligen Stufen.

3. Vorrichtung zur Durchführung des Verfahrens nach Anspruch 1, gekennzeichnet durch einen dem Quarzoszillator (35) zugeordneten Frequenzteiler (38) mit festem Teilungsverhältnis, der die Frequenz ($f_Q$) des Quarzoszillators derart teilt, daß die Vergleichsfrequenz ($f_V$) in der Größenordnung der geteilten Mischfrequenz ($\frac{f_M}{n}$) liegt.

- 2 -

4. Vorrichtung nach Anspruch 2, dadurch gekennzeichnet, daß der einstellbare Frequenzteiler (25) zwischen einem ersten Tiefpaßfilter (23) und einer Phasenvergleichsstufe (27) liegt, an die sich ein zweites Tiefpaßfilter (29) und der spannungsgesteuerte Oszillator (30) des PLL-Sendeoszillators (20) anschließen.

5. Vorrichtung nach Anspruch 3, dadurch gekennzeichnet, daß der Frequenzteiler (38) mit festem Teilungsverhältnis zwischen dem Ausgang (37) des Quarzoszillators (35) und einem Eingang (39) der Phasenvergleichsstufe (27) liegt.

6. Vorrichtung nach Anspruch 2 oder 4, dadurch gekennzeichnet, daß der Frequenzteiler (25) mit einstellbarem Teilungsverhältnis und die Phasenvergleichsstufe (27) zu einer integrierten Schaltung zusammengefaßt sind.

7. Vorrichtung nach Anspruch 2, 3 oder 4, dadurch gekennzeichnet, daß der Frequenzteiler (25) mit einstellbarem Teilungsverhältnis, der Frequenzteiler (38) mit festem Teilungsverhältnis und die Phasenvergleichsstufe (27) zu einer integrierten Schaltung (41) zusammengefaßt sind.

8. Vorrichtung nach Anspruch 7, dadurch gekennzeichnet, daß der Frequenzteiler (25) mit einstellbarem Teilungsverhältnis, die Phasenvergleichsstufe (27), der Frequenzteiler (38) mit festem Teilungsverhältnis und der aktive Teil (52) des Quarzoszillators (35) zu einer integrierten Schaltung zusammengefaßt sind.

# Fig. 1

f_z ( 21,4 MHz)

$f_E$
(146...174 MHz)

$f_0$
(124,6...152,6 MHz)

$f_S$

$f_M = f_S - f_0$
(11...32 MHz)

$\frac{f_M}{n}$
(≈1MHz)

$f_V = \frac{f_Q}{a}$
(≈1MHz)

$f_Q$
( 8...9,6 MHz)

$f_M$ ( 0...3 kHz)

$f_Q{}'$

$U_R$

$f_S$
(146...174MHz)

1/2

Fig. 2

Europäisches Patentamt

**EUROPÄISCHER RECHERCHENBERICHT**

0058747

EP 81 10 7812

| Kategorie | Kennzeichnung des Dokuments mit Angabe. soweit erforderlich. der maßgeblichen Teile | betrifft Anspruch | KLASSIFIKATION DER ANMELDUNG (Int. Cl.) |
|---|---|---|---|
| | **EINSCHLÄGIGE DOKUMENTE** | | |
| Y | BULL. DES SCHWEIZERISCHEN ELEKTROTECHN.VEREINS, Band 64, Nr. 5, 3. März 1973 ZÜRICH (CH) S.MANSOUR u.a.: "Erzeugung winkelmodulierter Signale in einer Phasenregelschleife" Seiten 286-291 <br><br> * Seite 291, Absatz 6; Ausblich; Figur 14 * <br><br> -- | 1,2,4, 6 | H 03 C 3/09 |
| Y | US - A - 4 110 707 (W.H.GIOLMA u.a.) <br><br> * Spalte 3, Zeile 28 bis Spalte 5, Zeile 28; Figuren 2 und 3 * <br><br> -- | 1,2,4, 6 | RECHERCHIERTE SACHGEBIETE (Int. Cl.) <br><br> H 03 C <br> H 03 L <br> H 04 B |
| A | US - A - 4 189 689 (G.L.TRIPPLETT) <br><br> * Spalte 2, Zeile 41 bis Spalte 3, Zeile 6; Figur 1 * <br><br> -- | 1-5 | |
| A | US - A - 4 061 973 (F.A.REIMERS u.a.) <br><br> * Spalte 2, Zeile 23 bis Spalte 3, Zeile 38; Figur 1 * <br><br> -- | 1-5 | |
| A | ELECTRONIC COMPONENTS & APPLICA- TIONS, Band 3, Nr. 1, November 1980 EINDHOVEN (NL) P.R.BRENNAND u.a.: "Frequency synthesizer using LSI devices" Seiten 47-61 ./. | | |

| X | Der vorliegende Recherchenbericht wurde für alle Patentansprüche erstellt. |
|---|---|

| Recherchenort | Abschlußdatum der Recherche | Prüfer |
|---|---|---|
| DEN HAAG | 25. Mai 1982 | VAN WEEL |

EPA form 1503.1 06.78